# FASCICULE DE BREVET EUROPEEN

(11) **EP 2 747 528 B1**
(45) Date de publication et mention de la délivrance du brevet: **16.10.2019**
(21) Numéro de dépôt: 13195765.6
(22) Date de dépôt: 04.12.2013
(51) Int. Cl.: H05K 1/14, H05K 1/02, H01P 5/02

(54) **Dispositif d'interconnexion pour circuits électroniques, notamment des circuits électroniques hyperfrequence**
Vorrichtung zum Verbinden von elektronischen Schaltkreisen, insbesondere von elektronischen Höchstfrequenzschaltkreisen
Interconnection device for electronic circuits, in particular hyperfrequency electronic circuits

(30) Priorité: 21.12.2012 FR 1203566
(43) Date de publication de la demande: 25.06.2014
(73) Titulaire: Thales, 92400 Courbevoie (FR)
(72) Inventeur: Denis, Stéphane, 35340 La Bouexiere (FR); Leduc, Dominique, 35200 Rennes (FR); Fortel, Julien, 35000 Rennes (FR); Fouin, Patrick, 35770 Vern Sur Seiche (FR); Briantais, Didier, 35370 Etrelles (FR)
(74) Mandataire: Lucas, Laurent Jacques

(56) Documents cités:
- EP-A1- 2 391 191
- EP-A2- 1 301 061
- FR-A1- 2 799 887
- US-A1- 2005 248 001
- US-A1- 2009 151 994

## Description

La présente invention concerne un dispositif d'interconnexion pour circuits électroniques, notamment des circuits électroniques hyperfréquence. Elle s'applique notamment aux liaisons électroniques entre différents circuits électroniques.

La présente invention concerne des applications pour lesquelles des liaisons électriques sont requises, entre différents circuits électroniques. Pour la suite, la notion de circuit électronique est à comprendre dans son acception la plus large, c'est-à-dire qu'un circuit électronique peut se présenter sous la forme d'un module électronique, par exemple d'une puce, d'un microsystème électromécanique, habituellement désigné sous l'acronyme de "MEMS", pour l'expression anglo-saxonne de "Micro-Electro-Mechanical System", d'un circuit intégré en boîtier, d'un module de cartes imprimées simples ou empilées, d'un module tridimensionnel, etc. Ces liaisons peuvent relier électriquement des circuits électroniques physiquement homogènes : par exemple des puces entre elles, ou bien des circuits électroniques physiquement hétérogènes, lorsqu'il s'agit par exemple de relier électriquement une puce à un support d'interconnexion avec un substrat, une carte imprimée, un boîtier, etc. Les signaux considérés peuvent être de caractère numérique rapide ou bien analogique hyperfréquence.

Plus particulièrement, la présente invention se rapporte à des applications dans lesquelles les liaisons électriques précitées sont destinées à la transmission de signaux électriques occupant une large bande de fréquences, et/ou qui se situent dans des fréquences élevées en regard des dimensions des liaisons à réaliser, et/ou qui présentent des puissances élevées. Les signaux considérés peuvent être de nature analogique ou numérique. Il est par exemple considéré que des fréquences élevées en regard des dimensions des liaisons à réaliser, répondent à l'inégalité II>3.10⁹/1000.f, Il représentant la longueur de liaison en mètres, et f la fréquence du signal transmis, en Hertz.

Lorsque cette inégalité n'est pas satisfaite, la liaison réalisée est d'autant plus difficile à compenser que l'impédance caractéristique des interfaces est faible, que le niveau d'adaptation requis est élevé, et que la bande de fréquences d'intérêt est large. L'implantation d'un réseau d'adaptation n'est pas toujours possible, soit parce que la place disponible est insuffisante, soit parce que les éléments à interconnecter sont figés et non modifiables.

Dans le but de limiter l'influence parasite des éléments de liaison, réalisés par exemple sous la forme de fils ou de rubans, les circuits électroniques qui doivent être reliés électriquement sont placés à la plus grande proximité possible les uns des autres. Les fixations des éléments de liaison sont par exemple réalisées par des techniques de thermocompression ou de thermosonie. En conséquence, les dimensions et les tolérances qui y sont associées et qui sont associées au positionnement des éléments, sont réduites, au détriment des coûts de réalisation et des rendements de fabrication.

Cet inconvénient est d'autant plus critique que les assemblages considérés sont complexes et que de longues chaînes de dimensions sont impliquées. Par exemple, dans un cas relativement simple où des puces ou des modules de puissance sont montés sur des dissipateurs thermiques, au travers de cavités réalisées dans un substrat, une chaîne de dimensions peut être définie comme la somme de la distance de la plage de connexion sur le substrat par rapport au bord du substrat, de la distance du bord du substrat au bord de la puce ou du module, et de la distance du bord de la puce ou du module, à la plage de connexion sur la puce ou le module. Une tolérance fine associée à une telle chaîne de dimensions est réalisable en pratique, mais au prix de procédés de fabrication et de contrôle nécessairement coûteux, et au risque d'un rendement faible.

Un autre problème se posant dans ce contexte, est lié au fait qu'il est parfois nécessaire de relier des composants dans des assemblages dans lesquels ceux-ci présentent des points de fixation situés à des hauteurs différentes. Dans de tels cas, non seulement la différence de hauteur entre les composants ou circuits accroit la longueur de liaison, mais en outre la réalisation d'un retour de masse s'avère délicate.

Il existe des solutions connues de l'état de la technique, mises en oeuvre pour limiter l'influence des phénomènes parasites ou la désadaptation des connexions.

Une première technique connue consiste à utiliser des broches de connexion, dont les formes peuvent être diverses. Ces broches de connexion peuvent par exemple être des pointes traversantes, des lyres, ou encore des broches plates montées en surface de circuits imprimés. Un inconvénient de cette technique est qu'elle n'est pas efficace pour la transmission de signaux à haute fréquence, et pour la dissipation de fortes puissances.

Une deuxième technique connue consiste à utiliser un micro-câblage comprenant une pluralité de fils conducteurs en parallèle, habituellement deux fils. Une telle technique est cependant souvent limitée par la surface disponible sur les plages de connexion, dont la surface est limitée par la fréquence des signaux à transmettre. Elle est également limitée par le phénomène d'inductance mutuelle entre les fils conducteurs.

Une troisième technique connue consiste à utiliser un micro-câblage comprenant des micro-rubans. Cette technique présente cependant également l'inconvénient d'être limitée par la surface disponible sur les plages de connexion, dont la surface est limitée par la fréquence des signaux à transmettre. Un autre inconvénient de cette technique est qu'elle est nettement plus coûteuse à mettre en oeuvre de manière industrielle, en comparaison avec la deuxième technique filaire précitée.

Une quatrième technique connue consiste à utiliser des microbilles conductrices, brasées entre des plages métallisées de modules montés retournés les uns par rapport aux autres. Cette technique est connue sous le nom de technique de "puce retournée", et plus habituellement désignée selon la terminologie anglo-saxonne "flip-chip". Par exemple, une puce électronique ou un module équipé d'une matrice de billes conductrices - souvent désignée selon le sigle BGA, de l'expression anglo-saxonne "Ball Grid Array" - monté retourné sur un substrat. Cette technique est avantageuse pour des liaisons à très haute fréquence, et/ou à très large bande de fréquences. Cependant, cette technique est coûteuse à mettre en oeuvre de manière industrielle, et requiert des étapes supplémentaires dans le procédé de fabrication des dispositifs les mettant en oeuvre. En outre, cette technique présente l'inconvénient de ne pas être efficace en termes de dissipation thermique, lorsqu'elle est appliquée à des circuits électroniques monolithiques, de type puces. Elle peut s'avérer efficace lorsqu'elle est appliquée à des modules intégrant un dissipateur thermique, mais dans de tels cas la technique s'avère globalement très coûteuse à mettre en oeuvre de manière industrielle. Cette technique présente également l'inconvénient de nécessiter des puces ou des modules conçus spécifiquement pour ce type d'assemblages. Elle présente enfin un inconvénient lié à la difficulté, voire l'impossibilité, de réaliser des contrôles visuels sur les liaisons après assemblage.

Une cinquième technique connue consiste à utiliser des micro-plages de connexion, assemblées directement par brasure ou par collage sur des circuits électroniques montés retournés l'une par rapport à l'autre. Cette technique est similaire à la quatrième technique connue utilisant des microbilles, décrite ci-dessus. Par exemple, une puce électronique ou un module équipé d'une matrice de micro-plages métallisées de connexion - souvent désignée selon le sigle LGA, de l'expression anglo-saxonne "Land Grid Array" - monté retourné sur un substrat. Cette technique permet également de réaliser des liaisons à très haute fréquence et/ou très large bande. En revanche, cette technique n'est pas efficace pour assurer l'adaptation des différences de coefficients de dilatation entre les différents circuits électroniques. D'une manière similaire à la quatrième technique décrite ci-dessus, cette technique présente l'inconvénient de ne pas être efficace en termes de dissipation thermique, lorsqu'elle est appliquée à des circuits électroniques monolithiques, de type puces. Elle peut également s'avérer efficace lorsqu'elle est appliquée à des modules intégrant un dissipateur thermique, mais au prix d'une mise en oeuvre très coûteuse. Cette technique présente également l'inconvénient de nécessiter des puces ou des modules conçus spécifiquement pour ce type d'assemblages. Elle présente également un inconvénient lié à la difficulté, voire l'impossibilité, de réaliser des contrôles visuels des liaisons après assemblage, même lorsque certaines liaisons sont réalisées avec des plages qui remontent sur les côtés, par exemple pour des modules munis de castellations, selon des techniques spécifiques au LGA.

Une sixième technique connue consiste à utiliser des micro-plots de connexion destinés à la réalisation de liaisons par thermo-compression ou par collage. Cette technique permet la réalisation de liaisons à très haute fréquence et/ou à très large bande de fréquences. Cependant, cette technique ne permet pas d'assurer une dissipation thermique efficace. Elle présente également un inconvénient lié à la difficulté, voire l'impossibilité, de réaliser des contrôles visuels des liaisons après assemblage.

Une septième technique connue consiste en un collage automatique par bande, cette technique est habituellement désignée selon l'acronyme "TAB", pour l'expression anglo-saxonne de "Tape Automated Bonding". Cette technique se base sur un circuit électrique réalisé sur un substrat fin et souple, dont les pistes dépassent et sont directement micro-câblées sur les plots d'interconnexion des éléments à relier, par exemple par thermo-compression ou par brasure collective. Cette technique permet un mode de liaison collectif, c'est-à-dire que toutes les opérations de connexion pour un même circuit imprimé, peuvent être réalisées de manière simultanée. La technique TAB permet par exemple la réalisation de liaisons avec des lignes de transmission coplanaires, de type masse / signal / masse. De telles lignes présentent l'inconvénient d'être sensibles aux dissymétries, de nécessiter un minimum de six points de contact par liaison, de nécessiter des plans de masse de large surface, ainsi qu'une grande finesse dans la réalisation de la ligne centrale, en termes de largeur de piste et d'écart avec les lignes de masse, dans le but d'obtenir des impédances caractéristiques typiques de l'ordre de 50 Ω.

Les documents EP 1 301 061 A2, FR 2 799 887 A1 et EP 2 391 191 A1 divulguent des dispositifs d'interconnexion pour circuits électroniques.

Un but de la présente invention est de pallier les inconvénients propres aux dispositifs connus précités, en proposant un dispositif d'interconnexion pour circuits électroniques hyperfréquence, pouvant se substituer aux techniques connues d'interconnexion, le plus souvent filaires, ou également aux lignes de transmission coplanaires de type masse / signal / masse utilisées pour la réalisation de liaisons selon des techniques de type TAB. Un dispositif d'interconnexion selon l'invention permet la transmission de signaux électriques occupant une large bande de fréquences et/ou se situant à des fréquences élevées en regard des dimensions à réaliser et/ou présentant des puissances élevées, avec un niveau d'adaptation élevé.

La présente invention propose de relier électriquement les circuits électroniques avec un élément formant une ligne de transmission de longueur et d'impédance caractéristique appropriées. Cette approche est différente des approches connues de liaisons filaires qui sont plutôt de caractère localisé, alors qu'une ligne de transmission est de caractère distribué. Cette ligne de transmission présente une impédance caractéristique et dans certains cas très favorables un mode de propagation, très proches de ceux qui sont présentés aux interfaces des circuits électroniques à relier.

La présente invention permet de relier électriquement des composants radiofréquence en procurant une très large bande passante et/ou une distance d'interconnexion et/ou un niveau d'adaptation supérieur à ce qui est réalisable via les techniques connues de l'état de la technique. Pour un niveau d'adaptation et pour une largeur de bande passante donnés, les distances maximales admissibles entre éléments à connecter avec un dispositif d'interconnexion selon l'un des modes de réalisation de la présente invention, sont plus élevées qu'avec les solutions connues de l'état de la technique. Ces plus grandes distances permettent d'accroître toutes les dimensions et la plupart des tolérances sur les dimensions liées à l'interconnexion, telles que par exemple les précisions et distances de découpe des éléments interconnectés ou les précisions et les dimensions des usinages des supports.

Du fait que le dispositif d'interconnexion selon les divers modes de réalisation de l'invention forme une ligne de transmission, les performances - par exemple les pertes d'insertion et d'adaptation - de la liaison électrique dépendent peu de sa longueur, jusqu'à la fréquence de coupure de la liaison, qui résulte le plus souvent d'une résonance parasite dans laquelle sont également impliqués des éléments « périphériques » à l'interconnexion, comme par exemple des via et des pads de masse aux accès de circuits intégrés de type « MMIC », le sigle désignant la terminologie anglaise « Monolithic Microwave Integrated Circuit » ou de modules. Tel n'est pas le cas avec des liaisons connues utilisant des fils ou des rubans.

Un avantage de l'invention est de permettre la réalisation de liaisons électriques de type ligne à transmission, dont les dimensions permettent de relâcher les éléments d'une chaîne de dimensions, et d'éloigner les plages de connexion.

Un autre avantage de l'invention est qu'elle permet de réaliser des dispositifs d'interconnexion dont les dimensions sont plus réduites que des liaisons réalisées avec des lignes coplanaires du type masse / signal / masse, dont les assemblages sont de moindre complexité, et dont l'immunité vis-à-vis de phénomènes parasites est moindre.

Un autre avantage de l'invention est que le type de liaison électrique qu'elle propose supporte mieux, par rapport à des liaisons filaires, des puissances électriques élevées.

Encore un autre avantage de l'invention est que le type de liaison électrique qu'elle propose confine mieux les champs électromagnétiques, en comparaison à des liaisons filaires ou des liaisons par rubans de taille comparable. Cela permet de minimiser les couplages parasites entre des circuits électroniques disposés à proximité les uns des autres.

Encore un autre avantage de l'invention est qu'elle permet de tolérer des variations de dimensions liées aux possibles variations de températures et aux différents coefficients de dilatation des matériaux mis en oeuvre, pouvant typiquement induire des mouvements relatifs de l'ordre du micron.

A cet effet, l'invention a pour objet un dispositif d'interconnexion d'éléments à interconnecter tels que des modules ou circuits électroniques selon la revendication 1.

Dans un mode de réalisation de l'invention, ladite partie de la longueur du dispositif d'interconnexion peut être rendue flexible par au moins un rétrécissement de la largeur des lignes de transmission et de masse.

Dans un mode de réalisation de l'invention, ladite partie de la longueur du dispositif d'interconnexion peut être rendue flexible par au moins un repliement des lignes de transmission et de masse.

Dans un mode de réalisation de l'invention, le repliement des lignes de transmission et de masse peut présenter la forme d'un zigzag, dans le plan comprenant les lignes de transmission et de masse.

Dans un mode de réalisation de l'invention, le repliement des lignes de transmission et de masse peut présenter la forme d'une courbure, dans le plan comprenant les lignes de transmission et de masse.

Dans un mode de réalisation de l'invention, le repliement des lignes de transmission et de masse peut avoir la forme d'une courbure, suivant un axe orthogonal au plan comprenant les lignes de transmission et de masse.

Dans un mode de réalisation de l'invention, ladite partie de la longueur du dispositif d'interconnexion peut être rendue flexible par au moins un retrait du substrat diélectrique sur au moins une portion de la longueur du dispositif d'interconnexion.

Dans un mode de réalisation de l'invention, ladite partie de la longueur du dispositif d'interconnexion peut être rendue flexible par la réalisation du substrat diélectrique dans un matériau flexible, sur au moins une portion de la longueur du dispositif d'interconnexion.

Dans un mode de réalisation de l'invention, le dispositif d'interconnexion peut permettre la réalisation d'une interconnexion de type Masse / Signal / Masse, le dispositif d'interconnexion comprenant une première et une seconde lignes de masse et une ligne de transmission, les lignes de masse et de transmission étant réalisées sur une face du substrat diélectrique.

Dans un mode de réalisation de l'invention, le substrat diélectrique peut être défini de manière à ce que sa constante de dilatation soit inférieure ou égale à la constante de dilatation des lignes de transmission et de masse.

D'autres caractéristiques et avantages de l'invention apparaîtront à la lecture de la description, donnée à titre d'exemple, faite en regard des dessins annexés qui représentent :
- les figures 1A, 1B, 1C, respectivement une vue de dessus, de profil et de dessous d'un dispositif d'interconnexion selon un exemple de mode de réalisation de la présente invention, pour l'interconnexion de deux modules éléments ;
- la figure 2, une vue de dessous d'un dispositif d'interconnexion selon un autre mode de réalisation de l'invention ;
- les figure 3A et 3B, des vues respectivement de profil et de dessous, d'un dispositif d'interconnexion selon un autre exemple de mode de réalisation de la présente invention ;
- les figures 4A, 4B et 4C, respectivement une vue de dessus illustrant trois éléments à interconnecter, les trois éléments interconnectés au moyen d'un dispositif d'interconnexion selon un exemple de réalisation de l'invention, et une vue de dessous du dispositif d'interconnexion dans cet exemple ;
- la figure 5, une vue de profil illustrant de manière synoptique un dispositif d'interconnexion selon un autre exemple de réalisation de l'invention ;
- les figures 6A et 6B, respectivement une vue de dessus et une vue de dessous d'un dispositif d'interconnexion pour deux éléments selon un autre exemple de réalisation de l'invention ;
- les figures 7A et 7B, respectivement une vue de dessus et une vue de dessous d'un dispositif d'interconnexion pour trois éléments selon un autre exemple de réalisation de l'invention ;

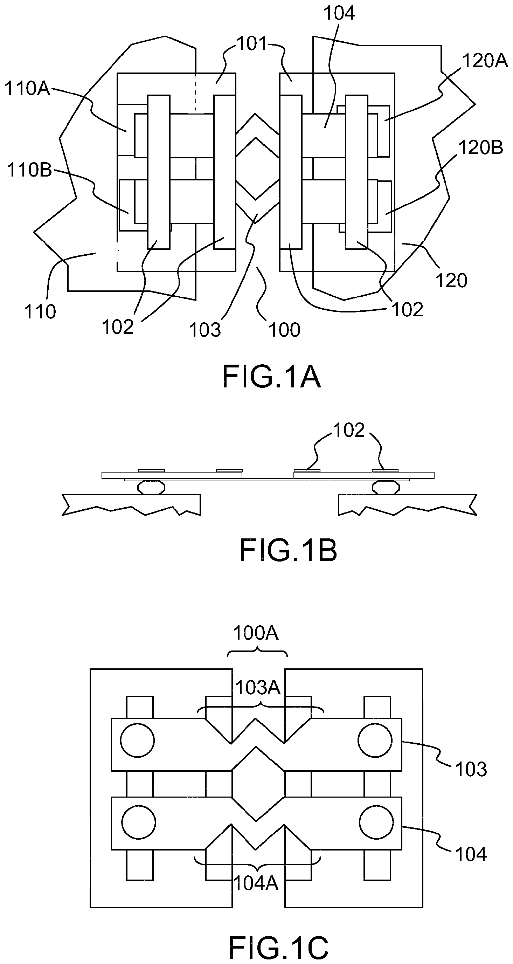

Les figures 1A, 1B, 1C présentent respectivement une vue de dessus, de profil et de dessous d'un dispositif d'interconnexion selon un exemple de mode de réalisation de la présente invention, pour l'interconnexion de deux modules éléments.

En référence à la figure 1A, un dispositif d'interconnexion 100 comprenant un substrat diélectrique 101, relie électriquement un premier élément 110, par exemple un module électronique, à un second élément 120, par exemple un module électronique. Dans l'exemple illustré par la figure, le premier élément 110 comprend deux plots de connexion 110A, 110B. Par exemple, le premier élément 110 peut comprendre un substrat diélectrique au sein duquel sont réalisées des pistes et des composants via une ou plusieurs couches de métallisations, et en surface duquel sont réalisées des surfaces métallisées formant les plots de connexion 110A, 110B. D'une manière similaire, le second élément 120 peut comprendre des plots de connexion 120A, 120B.

Le dispositif d'interconnexion 100 peut comprendre sur une face inférieure, une ligne de transmission 103 conductrice, disposée en parallèle, et couplée avec une ligne de masse 104, les lignes de transmission et de masse 103, 104 étant par exemple coplanaires. La disposition de la ligne de masse 104 et de la ligne de transmission 103 illustrée sur les figures 1A et 1C est un exemple non limitatif de l'invention, ces lignes pouvant notamment être interverties.

Le dispositif d'interconnexion 100 comprend avantageusement un ou une pluralité d'éléments de couplage 102 disposés sur la face supérieure du substrat diélectrique 101, permettant de renforcer le couplage entre les lignes de transmission et de masse 103, 104. Les éléments de couplage 102 sont par exemple disposés sur une surface globale correspondant sensiblement à la surface occupée par les lignes de transmission et de masse 103, 104. La face supérieure du substrat 101 ne comporte pas de masse, ou de plan de masse.

L'interconnexion entre les lignes de transmission et de masse 103, 104 avec les éléments à interconnecter peut se réaliser sensiblement au niveau des extrémités de celles-ci. En référence à la figure 1B, les extrémités des lignes de transmission et de masse 103, 104 peuvent être fixées aux plots de connexion 110A, 110B et 120A, 120B des éléments 110, 120 à interconnecter, par exemple par brasure ainsi que dans l'exemple illustré par la figure 1B, par thermo-compression, par collage ou bien par d'autres méthodes connues de fixation. Les extrémités peuvent être directement fixées aux plots, ou bien des plages ou plots de liaison peuvent être ménagés à l'extrémité des lignes de transmission et de masse 103, 104.

L'adaptation d'impédance peut être optimisée par un ajustement des formes, des largeurs des lignes de transmission et de masse 103, 104, et/ou par l'écart entre les lignes de transmission et de masse 103, 104 et/ou en ajustant le nombre et la forme des éléments de couplage 102. L'utilisation d'une pluralité de renforts de couplage 102 plutôt que d'un seul permet notamment de maximiser la bande passante de la structure. Les renforts de couplage ne sont pas des masses ou des lignes de transmission. En particulier ils ne sont reliés à aucun potentiel, de masse ou autre. Ils sont flottants d'un point de vue électrique.

Selon une spécificité de la présente invention, au moins une partie 100A de la longueur du dispositif d'interconnexion 100 est rendue flexible, cette partie étant située sensiblement entre les éléments à interconnecter 110, 120. La flexibilité de la partie 100A peut être assurée par un rétrécissement de la largeur des lignes de transmission 103 et de masse 104 et/ou par un repliement des lignes de transmission 103 et de masse 104 et/ou par un retrait total ou partiel - c'est-à-dire d'une totalité ou d'une partie de l'épaisseur - du substrat diélectrique 101 sur au moins une portion de la longueur du dispositif d'interconnexion et/ou par l'utilisation d'un substrat souple sur au moins une portion. Plus particulièrement, la structure peut être avantageusement rendu flexible par un repliement des lignes de transmission 103 dans le même plan que les substrats 101, la courbure des lignes étant dans le même plan que les substrats, c'est-à-dire dans le plan contenant les lignes de transmission et les lignes de masse. La variation d'impédance en résultant est alors compensée à l'aide des renforts de couplage 102. La courbure des lignes 103 peut également être réalisée dans une zone d'ablation de substrat où il est plus facile et plus efficace de mettre en oeuvre cette courbure, la variation d'impédance étant également compensée par les renforts de couplage 102.

Dans l'exemple non limitatif de la présente invention illustré par les figures 1A à 1C, la flexibilité est conférée par au moins une portion 103A de la ligne de transmission 103 et au moins une portion 104A de la ligne de masse 104 rendues flexibles grâce à un repliement de celles-ci en forme de zigzag et à un rétrécissement de leurs largeurs respectives, ainsi que par un retrait du substrat diélectrique 101 sur une portion correspondante de la longueur du dispositif d'interconnexion 100.

Une portion flexible d'une longueur de l'ordre du micromètre ou de quelques micromètres peut suffire dans de nombreux cas typiques.

Les éléments à interconnecter 110, 120 peuvent être des modules ou circuits électroniques ; ce dernier terme étant compris dans son acception la plus large. Il est par exemple possible de substituer les modules ou circuits électroniques par des puces électroniques, des modules tridimensionnels, des composants de type MEMS, ou encore des microsystèmes opto-électromécaniques, habituellement désignés selon l'acronyme MOEMS pour la terminologie anglo-saxonne de "Micro Opto-Electro-Mechanical System".

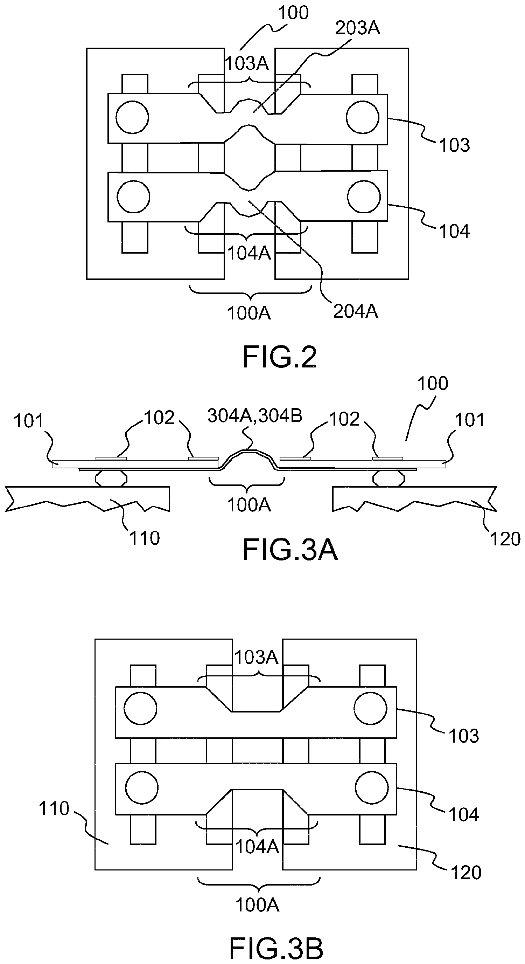

La figure 2 présente une vue de dessous d'un dispositif d'interconnexion selon un autre mode de réalisation de l'invention.

Dans l'exemple non limitatif de la présente invention illustré par la figure 2, le dispositif d'interconnexion 100 peut comprendre une partie flexible 100A formée par un rétrécissement de la largeur des lignes de transmission et de masse 103, 104 sur au moins une portion 103A, 104A de leurs longueurs respectives et/ou par une courbure 203A, 204A respectivement des lignes de transmission et de masse 103, 104 réalisée au sein de leur portion respective 103A, 104A, les courbures 203A, 204A étant dans l'exemple de la figure réalisées dans le plan principal comprenant les lignes de transmission et de masse 103, 104, ainsi que par un retrait du substrat diélectrique 101 sur au moins une portion et/ou par l'utilisation d'un substrat souple, à l'instar de l'exemple de réalisation précédent décrit ci-dessus en référence aux figures 1A à 1C.

Les figures 3A et 3B présentent des vues respectivement de profil et de dessous, d'un dispositif d'interconnexion selon un autre exemple de mode de réalisation de la présente invention.

D'une manière similaire aux exemples de réalisation décrits ci-dessus en référence aux figures 1A à 1C et 2, un dispositif d'interconnexion 100 pour l'interconnexion de deux éléments à interconnecter 110, 120, peut comprendre notamment un substrat diélectrique 101, une ligne de transmission (103), une ligne de masse 104, des éléments de couplage 102. Le dispositif d'interconnexion 100 est rendu flexible sur une partie de sa longueur 100A, à la fois par un retrait de substrat à l'instar des modes de réalisation précédents, et par une courbure courbure 303A, 304A respectivement des lignes de transmission et de masse 103, 104 réalisée au sein d'une portion respective 103A, 104A, les courbures 303A, 304A étant dans cet exemple réalisées suivant un axe vertical dans la figure, orthogonal au plan principal du dispositif d'interconnexion 100 dans lequel sont disposées les lignes de transmission et de masse 103, 104. Dans l'exemple illustré par les figures 3A et 3B, et ainsi que cela apparaît sur la figure 3B, la flexibilité du dispositif d'interconnexion 100 est également assurée au moyen d'un rétrécissement de la largeur des lignes de transmission et de masse 103, 104 au niveau de leurs portions respectives 103A, 104A.

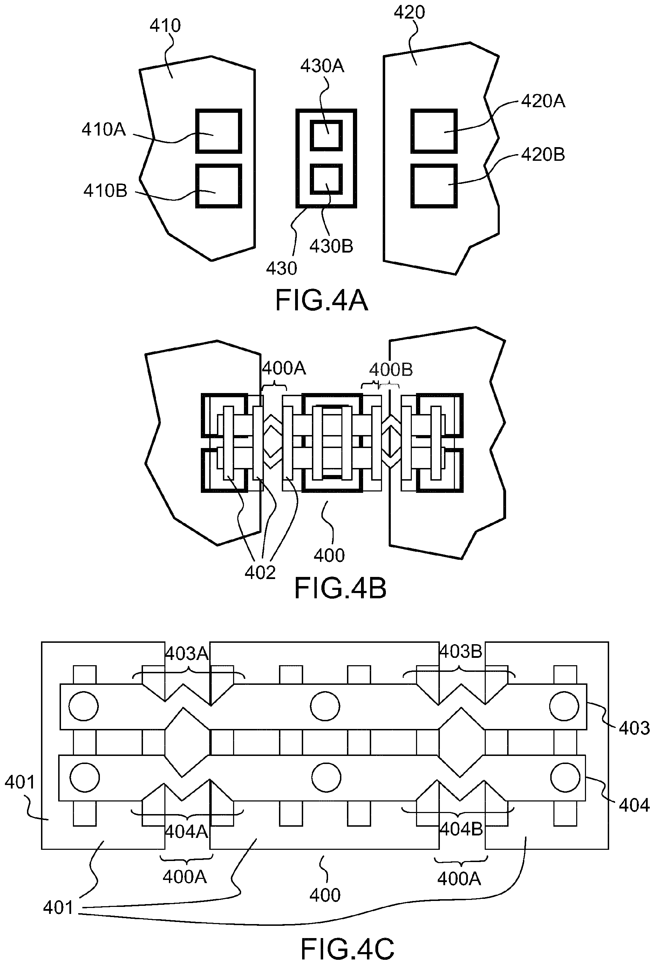

Les figures 4A à 4C présentent respectivement une vue de dessus illustrant trois éléments 410, 420, 430 à interconnecter, les trois éléments interconnectés au moyen d'un dispositif d'interconnexion 400 selon un exemple de réalisation de l'invention, et une vue de dessous du dispositif d'interconnexion dans cet exemple.

A l'instar des éléments à interconnecter 110, 120 illustrés notamment dans les figures 1A à 1C décrites précédemment, les éléments 410, 420, 430 à interconnecter peuvent comprendre respectivement des plots de connexion 410A et 410B, 420A et 420B, et 430A et 430B, ainsi que cela apparaît notamment dans les figures 4A et 4B, dans lesquelles à titre d'exemple le troisième élément à interconnecter 430 est disposé entre les premier et deuxième éléments à interconnecter 410, 420.

Un unique dispositif d'interconnexion 400 peut permettre la liaison entre les trois éléments à interconnecter 410, 420. Le dispositif d'interconnexion 400 comprend ainsi, d'une manière similaire aux modes de réalisation décrits précédemment, une ligne de transmission 403 et une ligne de masse 404, un substrat diélectrique 401, un ou une pluralité d'éléments de couplage 402, et est rendu flexible sur au moins deux parties 400A, 400B situées sensiblement respectivement entre le premier élément à interconnecter 410 et le troisième élément à interconnecter 430, et entre le troisième élément à interconnecter 430 et le deuxième élément à interconnecter 420.

La flexibilité est rendue possible par un ou plusieurs des moyens décrits précédemment. Dans l'exemple illustré par les figures 4A et 4B, la flexibilité est permise à la fois par un retrait du substrat diélectrique 401 sur deux parties de la longueur du dispositif d'interconnexion 400, ainsi que par un repliement des lignes de transmission et de masse 403, 404 en forme de zigzag au niveau de portions respectives 403A, 403B et 404A, 404B de celles-ci, et par un rétrécissement de leurs largeurs respectives au niveau desdites portions respectives.

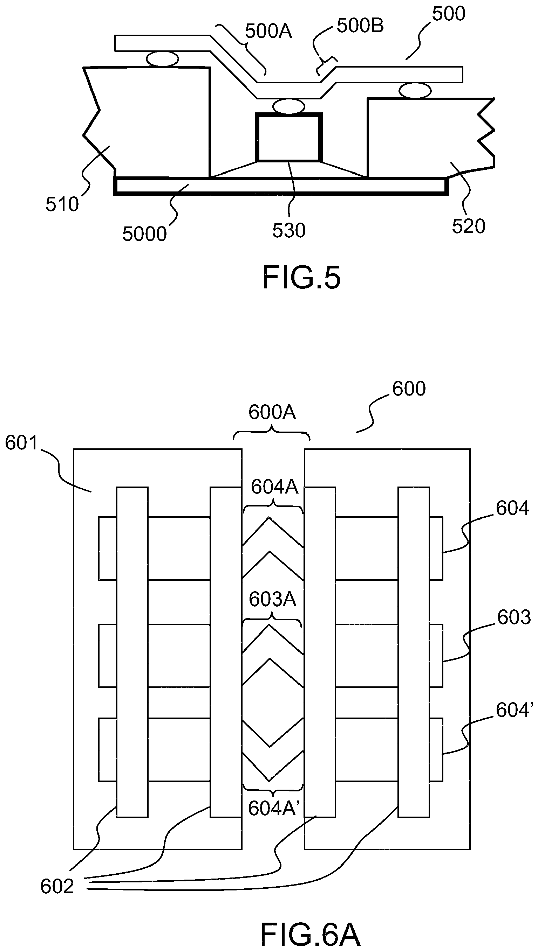

La figure 5 présente une vue de profil illustrant de manière synoptique un dispositif d'interconnexion selon un autre exemple de réalisation de l'invention.

Dans l'exemple illustré par la figure 5, trois éléments à interconnecter 510, 520 et 530 peuvent être reliés par un unique dispositif d'interconnexion 500 dans une configuration similaire au mode de réalisation décrit ci-dessus en référence aux figures 4A à 4C. Dans cet exemple, les éléments à interconnecter 510, 520 et 530 sont montés sur une même surface 5000 et présentent des épaisseurs différentes, de sortent que leur face supérieure, et partant leurs plots de liaison non représentés sur la figure, se situent à des hauteurs différentes.

Le dispositif d'interconnexion 500 étant rendu flexible sur au moins deux parties 500A et 500B situées sensiblement respectivement entre le premier élément 510 et le troisième élément 530 à interconnecter, et entre le troisième élément 530 et le deuxième élément 520 à interconnecter, celui-ci peut s'adapter à la configuration formée par les différents éléments à interconnecter.

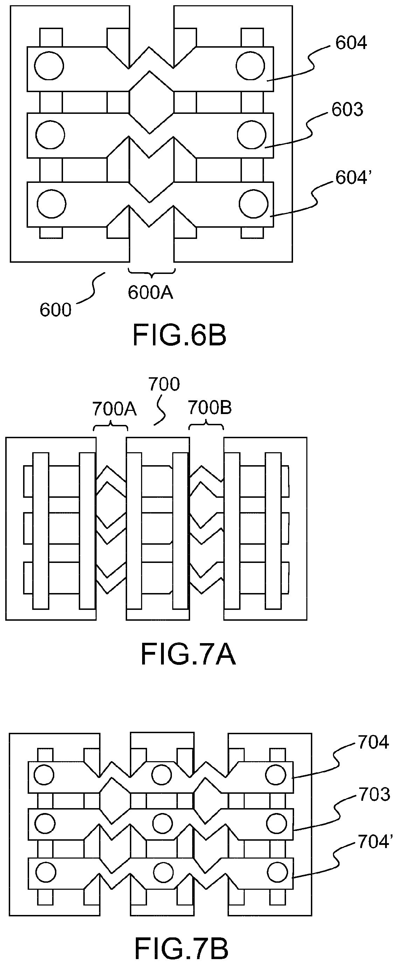

Les figures 6A et 6B présentent respectivement une vue de dessus et une vue de dessous d'un dispositif d'interconnexion 600 pour deux éléments selon un autre exemple de réalisation de l'invention. Un dispositif d'interconnexion selon la présente invention peut également être étendu à des interconnexions de type Masse / Signal / Masse.

La configuration du dispositif d'interconnexion 600 est similaire à la configuration présentée dans le mode de réalisation décrit précédemment en référence aux figures 1A à 1C, à l'exception qu'une interconnexion de type Masse / Signal / Masse est réalisée à partir de deux lignes de masse 604, 604' et d'une ligne de transmission 603, la ligne de transmission étant disposée entre les deux lignes de masse 604, 604', sensiblement en parallèle avec celles-ci. D'une manière également similaire au mode de réalisation décrit précédemment en référence aux figures 1A à 1C, une partie 600A de la longueur du dispositif d'interconnexion 600 est rendue flexible, cette partie étant située sensiblement entre les éléments à interconnecter 610, 620. Dans l'exemple non limitatif de la présente invention illustré par les figures 6A et 6B, la flexibilité est conféré par au moins une portion 603A de la ligne de transmission 603 et au moins une portion 604A et une portion 604A' respectivement des deux lignes de masse 604, 604' rendues flexibles grâce à un repliement de celles-ci en forme de zigzag et à un rétrécissement de leurs largeurs respectives, ainsi que par un retrait du substrat diélectrique 601 sur une portion correspondante de la longueur du dispositif d'interconnexion 600.

Les figures 7A et 7B présentent respectivement une vue de dessus et une vue de dessous d'un dispositif d'interconnexion 700 pour trois éléments selon un autre exemple de réalisation de l'invention.

La configuration illustrée par les figures 7A et 7B permet la liaison par le dispositif d'interconnexion 700 de trois éléments à interconnecter, à l'instar du mode de réalisation décrit précédemment en référence à la figure 4C, à l'exception que le dispositif d'interconnexion comprend deux lignes de masse 704, 704' et une ligne de transmission 703, à l'instar du dispositif d'interconnexion 600 décrit ci-dessus en référence aux figures 6A et 6B, le dispositif d'interconnexion 700 étant rendu flexible sur deux parties 700A, 700B.

Il peut être avantageux que l'assemblage des éléments à interconnecter et d'un dispositif d'interconnexion selon l'un des modes de réalisation de l'invention soit réalisé à une température supérieure ou égale à la température maximale de fonctionnement du dispositif, et que les matériaux choisis pour tous les éléments soient déterminés de sorte que l'interconnexion entre ceux-ci soit en compression à plus faible température. Par exemple, il peut être avantageux de choisir un substrat dont la constante de dilatation est substantiellement inférieure à celle du système dans lequel il s'insère. La constante de dilatation du substrat peut également être choisie égale ou légèrement inférieure à la constante de dilatation des lignes de transmission et de masse, car un effet bilame vers le haut est le plus souvent préférable, notamment si un plan de masse ou un obstacle inférieur se trouve à proximité.

La présente invention présente également l'avantage de permettre une meilleure maîtrise d'impédance et une moindre dispersion des performances. Elle est également bien adaptée à des signaux de forte puissance ou de forts courants.

## Revendications

1. Dispositif d'interconnexion (100) d'éléments (110, 120) à interconnecter tels que des modules ou circuits électroniques, comprenant au moins une ligne de transmission (103) couplée à une ligne de masse (104), les deux lignes (103, 104) étant réalisées sur la face inférieure d'un substrat diélectrique (101), l'interconnexion se réalisant sensiblement aux extrémités de la ligne de transmission (103) et de la ligne de masse (104), ledit dispositif comprend en outre au moins une surface de métallisation formant sur la face supérieure du substrat diélectrique (101) au moins un élément de couplage (102) pour le renforcement du couplage électrique entre les deux lignes (103, 104), ladite surface de métallisation étant flottante électriquement,
**caractérisé en ce que** ledit dispositif d'interconnexion (100) étant flexible sur au moins une partie de sa longueur (100A) située sensiblement entre les éléments (110, 120) à interconnecter.

2. Dispositif d'interconnexion (100) selon la revendication 1, **caractérisé en ce que** ladite partie de la longueur (100A) du dispositif d'interconnexion (100) est rendue flexible par au moins un rétrécissement de la largeur des lignes de transmission (103) et de masse (104).

3. Dispositif d'interconnexion (100) selon l'une quelconque des revendications précédentes, **caractérisé en ce que** ladite partie de la longueur (100A) du dispositif d'interconnexion (100) est rendue flexible par au moins un repliement des lignes de transmission (103) et de masse (104).

4. Dispositif d'interconnexion (100) selon la revendication 3, **caractérisé en ce que** le repliement des lignes de transmission et de masse (103, 104) présente la forme d'un zigzag, dans le plan comprenant les lignes de transmission (103) et de masse (104).

5. Dispositif d'interconnexion (100) selon la revendication 3, **caractérisé en ce que** le repliement des lignes de transmission et de masse (103, 104) présente la forme d'une courbure, dans le plan comprenant les lignes de transmission (103) et de masse (104).

6. Dispositif d'interconnexion (100) selon la revendication 3, **caractérisé en ce que** le repliement des lignes de transmission et de masse (103, 104) a la forme d'une courbure, suivant un axe orthogonal au plan comprenant les lignes de transmission (103) et de masse (104).

7. Dispositif d'interconnexion (100) selon l'une quelconque des revendications précédentes, **caractérisé en ce que** ladite partie de la longueur (100A) du dispositif d'interconnexion (100) est rendue flexible par au moins un retrait du substrat diélectrique (101) sur au moins une portion de la longueur du dispositif d'interconnexion (100).

8. Dispositif d'interconnexion (100) selon l'une quelconque des revendications précédentes, **caractérisé en ce que** ladite partie de la longueur (100A) du dispositif d'interconnexion (100) est rendue flexible par la réalisation du substrat diélectrique (101) dans un matériau flexible, sur au moins une portion de la longueur du dispositif d'interconnexion (100).

9. Dispositif d'interconnexion (100, 600) selon l'une quelconque des revendications précédentes, **caractérisé en ce qu'**il permet la réalisation d'une interconnexion de type Masse / Signal / Masse, le dispositif d'interconnexion (100, 600) comprenant une première et une seconde lignes de masse (604, 604') et une ligne de transmission (603), les lignes de masse (604, 604') et de transmission (603) étant réalisées sur une face du substrat diélectrique (101, 601).

10. Dispositif d'interconnexion (100, 600) selon l'une quelconque des revendications précédentes, **caractérisé en ce que** le substrat diélectrique (101) est défini de manière à ce que sa constante de dilatation soit inférieure ou égale à la constante de dilatation des lignes de transmission (103, 603) et de masse (104, 604, 604').

## Patentansprüche

1. Vorrichtung zum Verbinden (100) von zu verbindenden Elementen (110, 120) wie elektronischen Modulen oder Schaltkreisen, umfassend wenigstens eine mit einer Masseleitung (104) gekoppelte Übertragungsleitung (103), wobei die beiden Leitungen (103, 104) auf der Unterseite eines dielektrischen Substrats (101) realisiert sind, wobei die Verbindung im Wesentlichen an den Enden der Übertragungsleitung (103) und der Masseleitung (104) erfolgt,
wobei die Vorrichtung ferner wenigstens eine Metallisierungsfläche umfasst, die auf der Oberseite des dielektrischen Substrats (101) wenigstens ein Kopplungselement (102) zum Verstärken der elektrischen Kopplung zwischen den beiden Leitungen (103, 104) bildet, wobei die Metallisierungsfläche elektrisch schwebend ist,
**dadurch gekennzeichnet, dass** die Verbindungsvorrichtung (100) auf wenigstens einem Teil ihrer Länge (100A) flexibel ist, die sich im Wesentlichen zwischen den zu verbindenden Elementen (110, 120) befindet.

2. Verbindungsvorrichtung (100) nach Anspruch 1, **dadurch gekennzeichnet, dass** der Teil der Länge (100A) der Verbindungsvorrichtung (100) durch wenigstens eine Verringerung der Breite der Übertragungsleitung (103) und der Masseleitung (104) flexibel gemacht wird.

3. Verbindungsvorrichtung (100) nach einem der vorherigen Ansprüche, **dadurch gekennzeichnet, dass** der Teil der Länge (100A) der Verbindungsvorrichtung (100) durch wenigstens eine Faltung der Übertragungsleitung (103) und der Masseleitung (104) flexibel gemacht wird.

4. Verbindungsvorrichtung (100) nach Anspruch 3, **dadurch gekennzeichnet, dass** die Faltung der Übertragungs- und Masseleitung (103, 104) eine Zickzack-Form in der Ebene aufweist, die die Übertragungsleitung (103) und die Masseleitung (104) umfasst.

5. Verbindungsvorrichtung (100) nach Anspruch 3, **dadurch gekennzeichnet, dass** die Faltung der Übertragungs- und Masseleitung (103, 104) eine Kurvenform in der Ebene aufweist, die die Übertragungsleitung (103) und die Masseleitung (104) umfasst.

6. Verbindungsvorrichtung (100) nach Anspruch 3, **dadurch gekennzeichnet, dass** die Faltung der Übertragungs- und Masseleitung (103, 104) eine Kurvenform entlang einer Achse orthogonal zu der Ebene aufweist, die die Übertragungsleitung (103) und die Masseleitung (104) umfasst.

7. Verbindungsvorrichtung (100) nach einem der vorherigen Ansprüche, **dadurch gekennzeichnet, dass** der Teil der Länge (100A) der Verbindungsvorrichtung (100) durch wenigstens eine Aussparung in dem dielektrischen Substrat (101) auf wenigstens einem Abschnitt der Länge der Verbindungsvorrichtung (100) flexibel gemacht wird.

8. Verbindungsvorrichtung (100) nach einem der vorherigen Ansprüche, **dadurch gekennzeichnet, dass** der Teil der Länge (100A) der Verbindungsvorrichtung (100) durch Fertigen des dielektrischen Substrats (101) in einem flexiblen Material auf wenigstens einem Abschnitt der Länge der Verbindungsvorrichtung (100) flexibel gemacht wird.

9. Verbindungsvorrichtung (100, 600) nach einem der vorherigen Ansprüche, **dadurch gekennzeichnet, dass** sie die Herstellung einer Verbindung des Masse/Signal/Masse-Typs zulässt, wobei die Verbindungsvorrichtung (100, 600) eine erste und eine zweite Masseleitung (604, 604') und eine Übertragungsleitung (603) umfasst, wobei die Masseleitungen (604, 604') und die Übertragungsleitung (603) auf einer Fläche des dielektrischen Substrats (101, 601) hergestellt sind.

10. Verbindungsvorrichtung (100, 600) nach einem der vorherigen Ansprüche, **dadurch gekennzeichnet, dass** das dielektrische Substrat (101) derart definiert ist, dass ihre Ausdehnungskonstante gleich oder kleiner ist als die Ausdehnungskonstante der Übertragungs- (103, 603) und Masseleitungen (104, 604, 604').

## Claims

1. An interconnection device (100) for elements (110, 120) to be interconnected, such as electronic modules or circuits, comprising at least one transmission line (103) coupled to a ground line (104), the two lines (103, 104) being produced on the lower face of a dielectric substrate (101), the interconnection being made substantially at the ends of the transmission line (103) and of the ground line (104),
said device further comprising at least one metallizing surface forming, on the upper face of the dielectric substrate (101), at least one coupling element (102) for strengthening the electric coupling between the two lines (103, 104), said metallizing surface being electrically floating,
**characterised in that** said interconnection device (100) is flexible on at least one part of its length (100A) that is substantially located between the elements (110, 120) to be interconnected.

2. The interconnection device (100) as claimed in claim 1, **characterised in that** said part of the length (100A) of the interconnection device (100) is made flexible by at least one reduction in the width of the transmission (103) and ground (104) lines.

3. The interconnection device (100) as claimed in any one of the preceding claims, **characterised in that** said part of the length (100A) of the interconnection device (100) is made flexible by at least one fold of the transmission (103) and ground (104) lines.

4. The interconnection device (100) as claimed in claim 3, **characterised in that** the fold of the transmission and ground lines (103, 104) is in the form of a zig-zag, in the plane comprising the transmission (103) and ground (104) lines.

5. The interconnection device (100) as claimed in claim 3, **characterised in that** the fold of the transmission and ground lines (103, 104) is in the form of a curve, in the plane comprising the transmission (103) and ground (104) lines.

6. The interconnection device (100) as claimed in claim 3, **characterised in that** the fold of the transmission and ground lines (103, 104) is in the form of a curve, along an axis orthogonal to the plane comprising the transmission (103) and ground (104) lines.

7. The interconnection device (100) as claimed in any one of the preceding claims, **characterised in that** said part of the length (100A) of the interconnection device (100) is made flexible by at least one recess in the dielectric substrate (101) on at least one portion of the length of the interconnection device (100).

8. The interconnection device (100) as claimed in any one of the preceding claims, **characterised in that** said part of the length (100A) of the interconnection device (100) is made flexible by producing the dielectric substrate (101) in a flexible material, on at least one portion of the length of the interconnection device (100).

9. The interconnection device (100, 600) as claimed in any one of the preceding claims, **characterised in that** it allows a ground/signal/ground type interconnection to be made, the interconnection device (100, 600) comprising a first and a second ground line (604, 604') and a transmission line (603), the ground (604, 604') and transmission (603) lines being produced on a face of the dielectric substrate (101, 601).

10. The interconnection device (100, 600) as claimed in any one of the preceding claims, **characterised in that** the dielectric substrate (101) is defined so that its expansion constant is less than or equal to the expansion constant of the transmission (103, 603) and ground (104, 604, 604') lines.
